# EUROPEAN PATENT APPLICATION

(11) **EP 4 589 617 A1**
(43) Date of publication of application: **23.07.2025**
(21) Application number: 24152946.0
(22) Date of filing: 19.01.2024
(51) Int. Cl.: H01H 11/00

(54) **SWITCHGEAR EVENT DETECTION SYSTEM**

(71) Applicant: ABB SCHWEIZ AG, 5400 Baden (CH)
(72) Inventor: KAUL, Holger, 68165 Mannheim (DE); LOSS, Theresa, 68167 Mannheim (DE); BOYACI, Aydin, 76337 Waldbronn (DE); GITZEL, Ralf, 68165 Mannheim (DE); PENNER, Simon, 67574 Osthofen (DE); MIGUNOV, Vadim, 68526 Ladenburg (DE); BOY, Felix, 69120 Heidelberg (DE)
(74) Representative: Maiwald GmbH

(57) **Abstract**

The present invention relates to a switchgear event detection system, comprising: one or more vibration/acoustic sensors (10); a processing unit (20); and an output unit (30);
wherein the one or more vibration/acoustic sensors are configured to be mounted in and/or on a switchgear;
wherein the one or more vibration/acoustic sensors are configured to acquire one or more vibration/acoustic signals relating to an event inside the switchgear and/or outside the switchgear and in the vicinity of the switchgear, and wherein the one or more vibration/acoustic signals extend over a time window;
wherein the one or more vibration/acoustic sensor are configured to provide the one or more vibration/acoustic signals to the processing unit;
wherein the processing unit is configured to compare at least a portion of the one or more vibration/acoustic signals with a plurality of reference vibration/acoustic signals stored within a database (40), wherein the plurality of reference vibration/acoustic signals relate to a N different reference events and wherein information of the N different reference events is stored in the database, and wherein each reference event of the N different reference events is associated with a different one or more reference vibration/acoustic signals of the plurality of reference vibration/acoustic signals;
wherein the processing unit is configured to classify the event as a specific reference event of the N different reference events when a match of the comparison between the at least a portion of the one or more vibration/acoustic signals relating to the event and the one or more reference vibration/acoustic signals of the plurality of reference vibration/acoustic signals associated with the specific reference event exceeds a first threshold; and
wherein the output unit is configured to output information on the event comprising utilization of information of the specific reference event stored in the database.

## Description

### FIELD OF THE INVENTION

The present invention relates to a switchgear event detection system, a switchgear event detection method, as well as a computer program element.

### BACKGROUND OF THE INVENTION

There are multiple events in a switchgear which can negatively affect operations of substations (HV, MV, LV). This includes unauthorized manipulations of switchgears, humans or animals trespassing upon the substation area. There are safety-related events, operational-related events, and environmental-related events such as:
(1) Safety-related events: Some events in electrical equipment can ultimately lead to catastrophic failure.
(2) Operational-related events: Some events can harm the switchgear itself (e.g., incorrect operation of a component, animal in the switchgear).
(3) Environmental events: Environmental events e.g., earthquakes can affect a switchgear.

Detecting safety-related events, operational-related events, and environmental events before they lead to harmful consequences and acting upon it is of high importance.

### SUMMARY OF THE INVENTION

Therefore, it would be advantageous to have an improved switchgear event detection system.

The object of the present invention is solved with the subject matter of the independent claims, wherein further embodiments are incorporated in the dependent claims.

In a first aspect, there is provided a switchgear event detection system, comprising:
- one or more vibration/acoustic sensors;
- a processing unit; and
- an output unit.

The one or more vibration/acoustic sensors are configured to be mounted in and/or on a switchgear. The one or more vibration/acoustic sensors are configured to acquire one or more vibration/acoustic signals relating to an event inside the switchgear and/or outside the switchgear and in the vicinity of the switchgear. The one or more vibration/acoustic signals extend over a time window. The one or more vibration/acoustic sensor are configured to provide the one or more vibration/acoustic signals to the processing unit. The processing unit is configured to compare at least a portion of the one or more vibration/acoustic signals with a plurality of reference vibration/acoustic signals stored within a database. The plurality of reference vibration/acoustic signals relate to a N different reference events and wherein information of the N different reference events is stored in the database. Each reference event of the N different reference events is associated with a different one or more reference vibration/acoustic signals of the plurality of reference vibration/acoustic signals. The processing unit is configured to classify the event as a specific reference event of the N different reference events when a match of the comparison between the at least a portion of the one or more vibration/acoustic signals relating to the event and the one or more reference vibration/acoustic signals of the plurality of reference vibration/acoustic signals associated with the specific reference event exceeds a first threshold . The output unit is configured to output information on the event comprising utilization of information of the specific reference event stored in the database.

Thus, vibration and /or acoustic sensors are used to detect and classify events by computing feature-based event fingerprints and comparing them to a database. Based on a classification algorithm, events are then characterized and classified.

It is to be noted that the one or more vibration/acoustic sensors are configured to be mounted in and/or on a switchgear includes that the one or more vibration/acoustic sensors are configured to be mounted on or to components of the switchgear, such as a circuit breaker, earthing switch etc.

The first threshold can be considered to be an event detection criteria or event detection indicator or event detection marker. The first threshold can for example be a simple threshold based on a single feature, a residual threshold, a threshold applied to a similarity measure / ML algorithm etc. / which is run on a set of features. The first threshold can for example be dependent on how a similarity measure is defined.

Thus, the first threshold in in general a marker that is utilized in detecting an event. Hence, these signal characteristics can be described and differentiated by a set of features to characterize event duration, amplitudes, repetitiveness. This results in a set of proposed features:
Analytical features based on the envelope of the time signal (signal energy, peak energy, signal duration),
Alignment of events by using time compression / stretching methods such as dynamic time warping and/or circular shifting to detect temporary patterns.

Frequency and /or time-frequency characteristics such as specific coefficients or energy from Fourier transform, Wavelet transform or cepstral coefficients.

Excitation frequency estimation by autocorrelation.

Also, the raw measurement signal itself can be used as a feature.

In an example, the N different reference events comprises reference events inside at least one reference switchgear and/or outside the at least one reference switchgear; and/or the N different reference events comprises reference events inside the switchgear and/or outside the switchgear.

In other words, one or switchgear that are different to the present switchgear being monitored can have been used with appropriate vibration and/ acoustic sensors to generate and build a database of fingerprint sensor signals, with associated information regarding what has occurred to generate the signals. Alternatively or additionally, the present switchgear itself, that is being monitored with vibration and/or acoustic sensors could have undergone a series of tests and operational runs to generate and build a database of fingerprint sensor signals, with associated information regarding what has occurred to generate the signals.

In an example, the database is comprised within the processing unit.

In an example, the database is separate to the processing unit.

Thus, the database could be within a memory that is local to the processing unit, or be held separately. Thus, if held separately a whole range of switchgear could access one database of common fingerprint sensor data and associated information as to what occurred to generate the signal fingerprints.

In an example, the processing unit is configured to classify the event as an unknown event when matches of comparisons between the at least a portion of the one or more vibration/acoustic signals relating to the event and each of the plurality of reference vibration/acoustic signals are less than the first threshold.

The database can for example be accessed with respect to events classified as unknown events to update the database, thus for example unknown events for circuit breakers in different switchgear, that could be the same or different types of circuit breakers can update the database.

In an example, the processing unit is configured to classify the event as an unknown event when matches of comparisons between the at least a portion of the one or more vibration/acoustic signals relating to the event and each of the plurality of reference vibration/acoustic signals are greater than a second threshold.

Thus, a determination can be made that some form of event has occurred, to stop the system from considering normal background noise to constitute an event, but the event itself cannot be classified.

The second threshold can be similar to the first threshold, in terms of being a form of criteria, but is utilized such that not all comparisons that are below the first threshold are classified as unknown events, which otherwise would mean that background noise would be classified as unknown events. Thus, the second threshold is simply utilized to provide a confidence level that an event, and not just noise, has been detected but cannot be classified as such and thus is classified as unknown.

In an example, the processing unit is configured to control the output unit to output an alarm when the event has been classified as an unknown event.

In this manner, and operator can be made aware that an unknown event has occurred, and investigate further.

In an example, the processing unit is configured to determine a severity level comprising utilization of the information of the specific reference event stored in the database, and wherein the information on the event output by the output unit comprises the severity level.

There could be a whole series of severity levels ranging from low level, medium level, high level, or critical level for example.

Thus, an operator is made aware of an event having occurred and provided with information regarding its severity level, enabling the operator to act immediately if necessary.

In an example, the processing unit is configured to control the output unit to output information relating the event when the event has been classified as an unknown event. The system comprises an input unit (50), and the input unit is configured to enable information on the event to be input by an operator, and the information on the event classifies the event. The processing unit is configured to update the database with the one or more vibration/acoustic signals relating to the event that is stored as new one or more reference vibration/acoustic signals along with the information on the event that classified the event.

In this way, a form of feedback loop is provided, where expert operators can update the database with fingerprint vibration and/or acoustic information of an event that was unknown, but the operator recognizes and7or already knows what it is, and the event then becomes a known reference event. When this even occurs again, the system then recognise it and provide information on what has occurred. Also, the operator can train the classifier in this manner, by generating events himself, that are initially output as unknown, and the operator then inputs what has occurred. The operator can then repeat the event a number of times, where slightly different vibration and/or acoustic signals are generated, and where the system may not initially recognise the event and outputs an unknown event "alarm". The operator can however input that it is the same event, and continue repeating this process until the system can recognise the vibration and/or acoustic signal in all its variations, for this event, as the event.

In an example, the processing unit is configured to cut each of the one or more vibration/acoustic signals relating to the event into a plurality of segments each extending over a different part of the time window. The processing unit is configured to compare each segment of the one or more vibration/acoustic signals with the plurality of reference vibration/acoustic signals stored within the database. The processing unit is configured to classify the event as the specific reference event of the N different reference events when matches of comparisons between two or more segments of the plurality of segments of the one or more vibration/acoustic signals relating to the event and the one or more reference vibration/acoustic signals of the plurality of reference vibration/acoustic signals associated with the specific reference event exceed the first threshold.

This enables better identification and classification of events, because some events occur over a short timescale and some over a longer timescale and by segmentation both long and short events can be identified and classified. Also, the same event that occurs over a relatively long time period may have very similar portions in parts of the time window and other portions of the signal can be different. By segmenting the signal and comparing each part, when a number of the parts of the signal match associated parts of a stored fingerprint signal a positive identification can be made when the match is above a threshold, when the whole signal itself may not match above such a positive classification threshold.

It is to be noted that segments that each extend over a different part of the time window, includes that some segments can overlap, but need not overlap.

In an example, the processing unit is configured to classify the event as an unknown event when matches of comparisons between two or more segments of the one or more vibration/acoustic signals relating to the event and each of the plurality of reference vibration/acoustic signals are less than the first threshold.

In this manner, a more positive indication that an event is truly unknown can be made.

The database can for example be accessed with respect to events classified as unknown events to update the database, thus for example unknown events for circuit breakers in different switchgear, that could be the same or different types of circuit breakers can update the database

In an example, the processing unit is configured to classify the event as an unknown event when matches of comparisons between the two or more segments of the one or more vibration/acoustic signals relating to the event and each of the plurality of reference vibration/acoustic signals are greater than the second threshold.

The second threshold can be similar to the first threshold, in terms of being a form of criteria, but is utilized such that not all comparisons that are below the first threshold are classified as unknown events, which otherwise would mean that background noise would be classified as unknown events. Thus, the second threshold is simply utilized to provide a confidence level that an event, and not just noise, has been detected but cannot be classified as such and thus is classified as unknown.

In an example, at least one segment of the plurality of segments extends over a different time period to at least one other segment of the plurality of segments.

In a second aspect, there is provided a switchgear comprising a system according to the first aspect.

In a third aspect, there is provided a switchgear event detection method, comprising:
- acquiring, by one or more vibration/acoustic sensors mounted in and/or on a switchgear, one or more vibration/acoustic signals relating to an event inside the switchgear and/or outside the switchgear and in the vicinity of the switchgear, and wherein the one or more vibration/acoustic signals extend over a time window;
- providing, by the one or more vibration/acoustic sensor, the one or more vibration/acoustic signals to a processing unit;
- comparing, by the processing unit, at least a portion of the one or more vibration/acoustic signals with a plurality of reference vibration/acoustic signals stored within a database (40), wherein the plurality of reference vibration/acoustic signals relate to a N different reference events and wherein information of the N different reference events is stored in the database, and wherein each reference event of the N different reference events is associated with a different one or more reference vibration/acoustic signals of the plurality of reference vibration/acoustic signals;
- classifying, by the processing unit is configured to classify the event as a specific reference event of the N different reference events when a match of the comparison between the at least a portion of the one or more vibration/acoustic signals relating to the event and the one or more reference vibration/acoustic signals of the plurality of reference vibration/acoustic signals associated with the specific reference event exceeds a first threshold; and
- outputting, by an output unit, information on the event comprising utilizing information of the specific reference event stored in the database.

In an example, the N different reference events comprises reference events inside at least one reference switchgear and/or outside the at least one reference switchgear; and/or the N different reference events comprises reference events inside the switchgear and/or outside the switchgear.

It is to be noted that the one or more vibration/acoustic sensors mounted in and/or on a switchgear includes that the one or more vibration/acoustic sensors are mounted on or to components of the switchgear, such as a circuit breaker, earthing switch etc.

The first threshold can be considered to be an event detection criteria or event detection indicator or event detection marker. The first threshold can for example be a simple threshold based on a single feature, a residual threshold, a threshold applied to a similarity measure / ML algorithm etc. / which is run on a set of features. The first threshold can for example be dependent on how a similarity measure is defined.

Thus, the first threshold in in general a marker that is utilized in detecting an event. Hence, these signal characteristics can be described and differentiated by a set of features to characterize event duration, amplitudes, repetitiveness. This results in a set of proposed features:
Analytical features based on the envelope of the time signal (signal energy, peak energy, signal duration),
Alignment of events by using time compression / stretching methods such as dynamic time warping and/or circular shifting to detect temporary patterns.

Frequency and /or time-frequency characteristics such as specific coefficients or energy from Fourier transform, Wavelet transform or cepstral coefficients.

Excitation frequency estimation by autocorrelation.

Also, the raw measurement signal itself can be used as a feature.

In an example, the database is comprised within the processing unit.

In an example, the database is separate to the processing unit.

In an example, the method comprises classifying, by the processing unit, the event as an unknown event when matches of comparisons between the at least a portion of the one or more vibration/acoustic signals relating to the event and each of the plurality of reference vibration/acoustic signals are less than the first threshold.

The database can for example be accessed with respect to events classified as unknown events to update the database, thus for example unknown events for circuit breakers in different switchgear, that could be the same or different types of circuit breakers can update the database

In an example, the method comprises classifying, by the processing unit, the event as an unknown event when matches of comparisons between the at least a portion of the one or more vibration/acoustic signals relating to the event and each of the plurality of reference vibration/acoustic signals are greater than a second threshold.

Thus, a determination can be made that some form of event has occurred, to stop the system from considering normal background noise to constitute an event, but the event itself cannot be classified.

The second threshold can be similar to the first threshold, in terms of being a form of criteria, but is utilized such that not all comparisons that are below the first threshold are classified as unknown events, which otherwise would mean that background noise would be classified as unknown events. Thus, the second threshold is simply utilized to provide a confidence level that an event, and not just noise, has been detected but cannot be classified as such and thus is classified as unknown.

In an example, the method comprises controlling, by the processing unit, the output unit to output an alarm when the event has been classified as an unknown event.

In an example, the processing unit is configured to determine a severity level comprising utilization of the information of the specific reference event stored in the database, and wherein the information on the event output by the output unit comprises the severity level.

There could be a whole series of severity levels ranging from low level, medium level, high level, or critical level for example.

Thus, an operator is made aware of an event having occurred and provided with information regarding its severity level, enabling the operator to act immediately if necessary.

In an example, the method comprises controlling, by the processing unit, the output unit to output information relating the event when the event has been classified as an unknown event, and wherein the method comprises inputting, by an input unit, information on the event by an operator, wherein the information on the event classifies the event, and wherein method comprises updating, by the processing unit, the database with the one or more vibration/acoustic signals relating to the event that is stored as new one or more reference vibration/acoustic signals along with the information on the event that classified the event.

In an example, the method comprises cutting, by the processing unit, each of the one or more vibration/acoustic signals relating to the event into a plurality of segments each extending over a different part of the time window, and the method comprises comparing, by the processing unit, each segment of the one or more vibration/acoustic signals with the plurality of reference vibration/acoustic signals stored within the database, and the method comprises classifying, by the processing unit, the event as the specific reference event of the N different reference events when matches of comparisons between two or more segments of the plurality of segments of the one or more vibration/acoustic signals relating to the event and the one or more reference vibration/acoustic signals of the plurality of reference vibration/acoustic signals associated with the specific reference event exceed the first threshold.

It is to be noted that segments that each extend over a different part of the time window, includes that some segments can overlap, but need not overlap.

In an example, the method comprises classifying, by the processing unit, the event as an unknown event when matches of comparisons between two or more segments of the one or more vibration/acoustic signals relating to the event and each of the plurality of reference vibration/acoustic signals are less than the first threshold.

The database can for example be accessed with respect to events classified as unknown events to update the database, thus for example unknown events for circuit breakers in different switchgear, that could be the same or different types of circuit breakers can update the database

In an example, the method comprises classifying, by the processing unit, the event as an unknown event when matches of comparisons between the two or more segments of the one or more vibration/acoustic signals relating to the event and each of the plurality of reference vibration/acoustic signals are greater than the second threshold. The second threshold can be similar to the first threshold, in terms of being a form of criteria, but is utilized such that not all comparisons that are below the first threshold are classified as unknown events, which otherwise would mean that background noise would be classified as unknown events. Thus, the second threshold is simply utilized to provide a confidence level that an event, and not just noise, has been detected but cannot be classified as such and thus is classified as unknown.

In an example, at least one segment of the plurality of segments extends over a different time period to at least one other segment of the plurality of segments.

In a fourth aspect, there is provided a computer program element for controlling a system which when executed by a processor is configured to carry out the method according to the third aspect.

In an example, there is provided a computer readable medium having stored the computer element of the ninth aspect.

The computer program elements can for example be a software program but can also be a FPGA, a PLD or any other appropriate digital means.

The above aspects and examples will become apparent from and be elucidated with reference to the embodiments described hereinafter.

### BRIEF DESCRIPTION OF THE DRAWINGS

Exemplary embodiments will be described in the following with reference to the following drawings:
Fig. 1 shows an exemplar switchgear event detection system;
Fig. 2 shows an exemplar switchgear event detection system;
Fig. 3 shows a a schematic representation of the creation or generation of reference vibration/acoustic signals or fingerprints;
Fig. 4 shows a detailed example of processing of a time vibration/acoustic signal of an event. Feature computation / classification; and
Fig. 5 shows examples of different sensor placements inside or outside of a switchgear, where numerous other locations can be used for sensor placement.

### DETAILED DESCRIPTION OF EMBODIMENTS

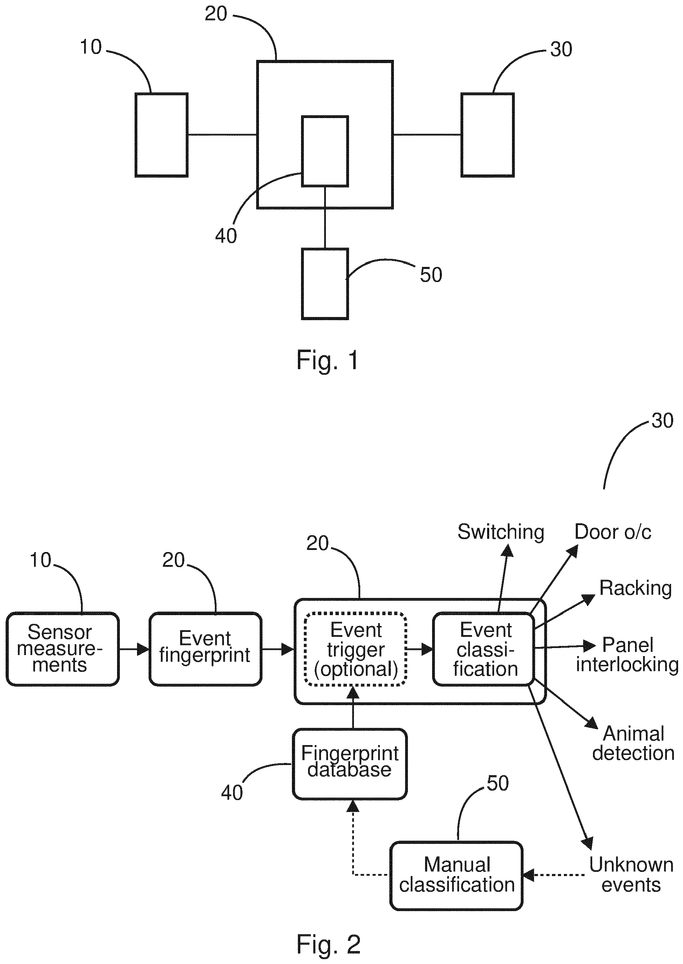

Fig. 1 shows an example switchgear event detection system, comprising:
- one or more vibration/acoustic sensors 10;
- a processing unit 20; and
- an output unit 30.

The one or more vibration/acoustic sensors are configured to be mounted in and/or on a switchgear. The one or more vibration/acoustic sensors are configured to acquire one or more vibration/acoustic signals relating to an event inside the switchgear and/or outside the switchgear and in the vicinity of the switchgear. The one or more vibration/acoustic signals extend over a time window. The one or more vibration/acoustic sensor are configured to provide the one or more vibration/acoustic signals to the processing unit. The processing unit is configured to compare at least a portion of the one or more vibration/acoustic signals with a plurality of reference vibration/acoustic signals stored within a database 40. The plurality of reference vibration/acoustic signals relate to a N different reference events and wherein information of the N different reference events is stored in the database. Each reference event of the N different reference events is associated with a different one or more reference vibration/acoustic signals of the plurality of reference vibration/acoustic signals. The processing unit is configured to classify the event as a specific reference event of the N different reference events when a match of the comparison between the at least a portion of the one or more vibration/acoustic signals relating to the event and the one or more reference vibration/acoustic signals of the plurality of reference vibration/acoustic signals associated with the specific reference event exceeds a first threshold. The output unit is configured to output information on the event comprising utilization of information of the specific reference event stored in the database.

Thus, vibration and /or acoustic sensors are used to detect and classify events by computing feature-based event fingerprints and comparing them to a database. Based on a classification algorithm, events are then characterized and classified.

It is to be noted that the one or more vibration/acoustic sensors are configured to be mounted in and/or on a switchgear includes that the one or more vibration/acoustic sensors are configured to be mounted on or to components of the switchgear, such as a circuit breaker, earthing switch etc.

The first threshold can be considered to be an event detection criteria or event detection indicator or event detection marker. The first threshold can for example be a simple threshold based on a single feature, a residual threshold, a threshold applied to a similarity measure / ML algorithm etc. / which is run on a set of features. The first threshold can for example be dependent on how a similarity measure is defined.

Thus, the first threshold in in general a marker that is utilized in detecting an event. Hence, these signal characteristics can be described and differentiated by a set of features to characterize event duration, amplitudes, repetitiveness. This results in a set of proposed features:
Analytical features based on the envelope of the time signal (signal energy, peak energy, signal duration),
Alignment of events by using time compression / stretching methods such as dynamic time warping and/or circular shifting to detect temporary patterns.

Frequency and /or time-frequency characteristics such as specific coefficients or energy from Fourier transform, Wavelet transform or cepstral coefficients.

Excitation frequency estimation by autocorrelation.

Also, the raw measurement signal itself can be used as a feature.

In an example, the N different reference events comprises reference events inside at least one reference switchgear and/or outside the at least one reference switchgear; and/or the N different reference events comprises reference events inside the switchgear and/or outside the switchgear.

In other words, one or switchgear that are different to the present switchgear being monitored can have been used with appropriate vibration and/ acoustic sensors to generate and build a database of fingerprint sensor signals, with associated information regarding what has occurred to generate the signals. Alternatively or additionally, the present switchgear itself, that is being monitored with vibration and7or acoustic sensors could have undergone a series of tests and operational runs to generate and build a database of fingerprint sensor signals, with associated information regarding what has occurred to generate the signals.

In an example, the database is comprised within the processing unit.

In an example, the database is separate to the processing unit.

Thus, the database could be within a memory that is local to the processing unit, or be held separately. Thus, if held separately a whole range of switchgear could access one database of common fingerprint sensor data and associated information as to what occurred to generate the signal fingerprints.

In an example, the processing unit is configured to classify the event as an unknown event when matches of comparisons between the at least a portion of the one or more vibration/acoustic signals relating to the event and each of the plurality of reference vibration/acoustic signals are less than the first threshold.

The database can for example be accessed with respect to events classified as unknown events to update the database, thus for example unknown events for circuit breakers in different switchgear, that could be the same or different types of circuit breakers can update the database.

In an example, the processing unit is configured to classify the event as an unknown event when matches of comparisons between the at least a portion of the one or more vibration/acoustic signals relating to the event and each of the plurality of reference vibration/acoustic signals are greater than a second threshold.

Thus, a determination can be made that some form of event has occurred, to stop the system from considering normal background noise to constitute an event, but the event itself cannot be classified.

The second threshold can be similar to the first threshold, in terms of being a form of criteria, but is utilized such that not all comparisons that are below the first threshold are classified as unknown events, which otherwise would mean that background noise would be classified as unknown events. Thus, the second threshold is simply utilized to provide a confidence level that an event, and not just noise, has been detected but cannot be classified as such and thus is classified as unknown.

In an example, the processing unit is configured to control the output unit to output an alarm when the event has been classified as an unknown event.

In this manner, and operator can be made aware that an unknown event has occurred, and investigate further.

In an example, the processing unit is configured to determine a severity level comprising utilization of the information of the specific reference event stored in the database, and wherein the information on the event output by the output unit comprises the severity level.

There could be a whole series of severity levels ranging from low level, medium level, high level, or critical level for example.

Thus, an operator is made aware of an event having occurred and provided with information regarding its severity level, enabling the operator to act immediately if necessary.

In an example, the processing unit is configured to control the output unit to output information relating the event when the event has been classified as an unknown event. The system comprises an input unit 50, and the input unit is configured to enable information on the event to be input by an operator, and the information on the event classifies the event. The processing unit is configured to update the database with the one or more vibration/acoustic signals relating to the event that is stored as new one or more reference vibration/acoustic signals along with the information on the event that classified the event.

In this way, a form of feedback loop is provided, where expert operators can update the database with fingerprint vibration and/or acoustic information of an event that was unknown, but the operator recognizes and7or already knows what it is and the event then becomes a known reference event. When this even occurs again, the system then recognise it and provide information on what has occurred. Also, the operator can train the classifier in this manner, by generating events himself, that are initially output as unknown, and the operator then inputs what has occurred. The operator can then repeat the event a number of times, where slightly different vibration and/or acoustic signals are generated, and where the system may not initially recognise the event and outputs an unknown event "alarm". The operator can however input that it is the same event, and continue repeating this process until the system can recognise the vibration and/or acoustic signal in all its variations, for this event, as the event.

In an example, the processing unit is configured to cut each of the one or more vibration/acoustic signals relating to the event into a plurality of segments each extending over a different part of the time window. The processing unit is configured to compare each segment of the one or more vibration/acoustic signals with the plurality of reference vibration/acoustic signals stored within the database 40. The processing unit is configured to classify the event as the specific reference event of the N different reference events when matches of comparisons between two or more segments of the plurality of segments of the one or more vibration/acoustic signals relating to the event and the one or more reference vibration/acoustic signals of the plurality of reference vibration/acoustic signals associated with the specific reference event exceed the first threshold.

This enables better identification and classification of events, because some events occur over a short timescale and some over a longer timescale and by segmentation both long and short events can be identified and classified. Also, the same event that occurs over a relatively long time period may have verx similar portions in parts of the time window and other portions of the signal can be different. By segmenting the signal and comparing each part, when a number of the parts of the signal match associated parts of a stored fingerprint signal a positive identification can be made when the match is above a threshold, when the whole signal itself may not match above such a positive classification threshold.

It is to be noted that segments that each extend over a different part of the time window, includes that some segments can overlap, but need not overlap.

In an example, the processing unit is configured to classify the event as an unknown event when matches of comparisons between two or more segments of the one or more vibration/acoustic signals relating to the event and each of the plurality of reference vibration/acoustic signals are less than the first threshold.

In this manner, a more positive indication that an event is truly unknown can be made.

The database can for example be accessed with respect to events classified as unknown events to update the database, thus for example unknown events for circuit breakers in different switchgear, that could be the same or different types of circuit breakers can update the database

In an example, the processing unit is configured to classify the event as an unknown event when matches of comparisons between the two or more segments of the one or more vibration/acoustic signals relating to the event and each of the plurality of reference vibration/acoustic signals are greater than the second threshold.

The second threshold can be similar to the first threshold, in terms of being a form of criteria, but is utilized such that not all comparisons that are below the first threshold are classified as unknown events, which otherwise would mean that background noise would be classified as unknown events. Thus, the second threshold is simply utilized to provide a confidence level that an event, and not just noise, has been detected but cannot be classified as such and thus is classified as unknown.

In an example, at least one segment of the plurality of segments extends over a different time period to at least one other segment of the plurality of segments.

From the above, it is clear that a switchgear can utilize a system as described with reaspect to Fig. 1.

Also, from the above descrioption of the system as described with respect to Fig. 1 it is clearr that an associated switchgear event detection method, comprises:
- acquiring, by one or more vibration/acoustic sensors mounted in and/or on a switchgear, one or more vibration/acoustic signals relating to an event inside the switchgear and/or outside the switchgear and in the vicinity of the switchgear, and wherein the one or more vibration/acoustic signals extend over a time window;
- providing, by the one or more vibration/acoustic sensor, the one or more vibration/acoustic signals to a processing unit;
- comparing, by the processing unit, at least a portion of the one or more vibration/acoustic signals with a plurality of reference vibration/acoustic signals stored within a database, wherein the plurality of reference vibration/acoustic signals relate to a N different reference events and wherein information of the N different reference events is stored in the database, and wherein each reference event of the N different reference events is associated with a different one or more reference vibration/acoustic signals of the plurality of reference vibration/acoustic signals;
- classifying, by the processing unit is configured to classify the event as a specific reference event of the N different reference events when a match of the comparison between the at least a portion of the one or more vibration/acoustic signals relating to the event and the one or more reference vibration/acoustic signals of the plurality of reference vibration/acoustic signals associated with the specific reference event exceeds a first threshold; and
- outputting, by an output unit, information on the event comprising utilizing information of the specific reference event stored in the database.

In an example, the N different reference events comprises reference events inside at least one reference switchgear and/or outside the at least one reference switchgear; and/or the N different reference events comprises reference events inside the switchgear and/or outside the switchgear.

It is to be noted that the one or more vibration/acoustic sensors mounted in and/or on a switchgear includes that the one or more vibration/acoustic sensors are mounted on or to components of the switchgear, such as a circuit breaker, earthing switch etc.

The first threshold can be considered to be an event detection criteria or event detection indicator or event detection marker. The first threshold can for example be a simple threshold based on a single feature, a residual threshold, a threshold applied to a similarity measure / ML algorithm etc. / which is run on a set of features. The first threshold can for example be dependent on how a similarity measure is defined.

Thus, the first threshold in in general a marker that is utilized in detecting an event. Hence, these signal characteristics can be described and differentiated by a set of features to characterize event duration, amplitudes, repetitiveness. This results in a set of proposed features:
Analytical features based on the envelope of the time signal (signal energy, peak energy, signal duration),
Alignment of events by using time compression / stretching methods such as dynamic time warping and/or circular shifting to detect temporary patterns.

Frequency and /or time-frequency characteristics such as specific coefficients or energy from Fourier transform, Wavelet transform or cepstral coefficients.

Excitation frequency estimation by autocorrelation.

Also, the raw measurement signal itself can be used as a feature.

In an example, the database is comprised within the processing unit.

In an example, the database is separate to the processing unit.

In an example, the method comprises classifying, by the processing unit, the event as an unknown event when matches of comparisons between the at least a portion of the one or more vibration/acoustic signals relating to the event and each of the plurality of reference vibration/acoustic signals are less than the first threshold.

The database can for example be accessed with respect to events classified as unknown events to update the database, thus for example unknown events for circuit breakers in different switchgear, that could be the same or different types of circuit breakers can update the database.

In an example, the method comprises classifying, by the processing unit, the event as an unknown event when matches of comparisons between the at least a portion of the one or more vibration/acoustic signals relating to the event and each of the plurality of reference vibration/acoustic signals are greater than a second threshold.

Thus, a determination can be made that some form of event has occurred, to stop the system from considering normal background noise to constitute an event, but the event itself cannot be classified.

The second threshold can be similar to the first threshold, in terms of being a form of criteria, but is utilized such that not all comparisons that are below the first threshold are classified as unknown events, which otherwise would mean that background noise would be classified as unknown events. Thus, the second threshold is simply utilized to provide a confidence level that an event, and not just noise, has been detected but cannot be classified as such and thus is classified as unknown.

In an example, the method comprises controlling, by the processing unit, the output unit to output an alarm when the event has been classified as an unknown event.

In an example, the processing unit is configured to determine a severity level comprising utilization of the information of the specific reference event stored in the database, and wherein the information on the event output by the output unit comprises the severity level.

There could be a whole series of severity levels ranging from low level, medium level, high level, or critical level for example.

Thus, an operator is made aware of an event having occurred and provided with information regarding its severity level, enabling the operator to act immediately if necessary.

In an example, the method comprises controlling, by the processing unit, the output unit to output information relating the event when the event has been classified as an unknown event, and wherein the method comprises inputting, by an input unit, information on the event by an operator, wherein the information on the event classifies the event, and wherein method comprises updating, by the processing unit, the database with the one or more vibration/acoustic signals relating to the event that is stored as new one or more reference vibration/acoustic signals along with the information on the event that classified the event.

In an example, the method comprises cutting, by the processing unit, each of the one or more vibration/acoustic signals relating to the event into a plurality of segments each extending over a different part of the time window, and the method comprises comparing, by the processing unit, each segment of the one or more vibration/acoustic signals with the plurality of reference vibration/acoustic signals stored within the database, and the method comprises classifying, by the processing unit, the event as the specific reference event of the N different reference events when matches of comparisons between two or more segments of the plurality of segments of the one or more vibration/acoustic signals relating to the event and the one or more reference vibration/acoustic signals of the plurality of reference vibration/acoustic signals associated with the specific reference event exceed the first threshold.

It is to be noted that segments that each extend over a different part of the time window, includes that some segments can overlap, but need not overlap.

In an example, the method comprises classifying, by the processing unit, the event as an unknown event when matches of comparisons between two or more segments of the one or more vibration/acoustic signals relating to the event and each of the plurality of reference vibration/acoustic signals are less than the first threshold.

The database can for example be accessed with respect to events classified as unknown events to update the database, thus for example unknown events for circuit breakers in different switchgear, that could be the same or different types of circuit breakers can update the database.

In an example, the method comprises classifying, by the processing unit, the event as an unknown event when matches of comparisons between the two or more segments of the one or more vibration/acoustic signals relating to the event and each of the plurality of reference vibration/acoustic signals are greater than the second threshold.

The second threshold can be similar to the first threshold, in terms of being a form of criteria, but is utilized such that not all comparisons that are below the first threshold are classified as unknown events, which otherwise would mean that background noise would be classified as unknown events. Thus, the second threshold is simply utilized to provide a confidence level that an event, and not just noise, has been detected but cannot be classified as such and thus is classified as unknown.

In an example, at least one segment of the plurality of segments extends over a different time period to at least one other segment of the plurality of segments.

The inventors realized that the present situation could be improved upon. Until now, only events linked to the main functionality of a switchgear have been traced by using specific sensors. The events Panel-interlocking, Door closing/opening, Racking-in/out, Shutter closing/opening have been performed without any sensor-based feedback to the operator. The same applies to the detection of animals (e.g.: snake, rat, cat, dog etc....) which may intrude the switchgear causing harm.

The inventors realized that vibration sensors and/or acoustic sensors could be used in a new way to enable the above events to be detected and identified.

Also, vibration sensors and/or acoustic sensors could be used in a new way to enable other events to be detected and identified, such as for person detection in the neighboring area of the switchgear panel or in the switchgear, where such detection is also of interest to increase the safety. These events can negatively affect operations of substations (high-voltage, medium-voltage, low-voltage), such as unauthorized manipulations of switchgears, humans or animals trespassing upon the substation area, and that now can be detected and identified. In addition, environmental events like earthquake detection or strong vibrations from neighboring machines or vehicles could be detected and identified and used for an environment history profile to link certain events to certain breaks and failures of the switchgear.

The new technique involves the use of vibration and /or acoustic sensors to detect and classify events by computing feature-based event fingerprints and comparing them to a database. Based on a classification algorithm, events are then characterized and classified. Feedback to the operator is triggered (e.g.: a safety-critical warning). Thereby, a health state of the switchgear including its components can be calculated and the switchgear maintenance procedure is improved. In addition, the new technique reduces the risk of workers on site, as well as damage and downtime due to failing equipment due to unauthorized manipulations or trespassing.

The new technique addresses safety-related events, where such events in electrical equipment can ultimately lead to catastrophic failure. Thus, panel-interlocking can be detected and identified. The panel-interlocking is an earthing switch that ensures a safe opening of switchgear by a human. The following safety relevant functions are included by the interlocking system: (a) The breaker must be open, (b) the busbars for the three phases has to be grounded by the mechanical system. The new technique enables for example the grounding event to be monitored, detected and identified to ensure a proper grounding of the busbars. Also, the closing and opening of doors of the switchgear can be detected and identified. The door of a switchgear can be only opened after a successful panel interlocking. However, a failure of the mechanical lock of the door could allow a human to open the door without a successful panel interlock. The new technique enables this event to be detected and identified to increase the safety of workers on the site, where if necessary the detected event could be compared to additional sensor data to further increase safety. The new technique enables for person detection and identification as such. The detection of a person in the neighboring area of the switchgear panel or in the switchgear can be used to increase the safety by combining this event with additional data or sensors to ensure e.g., that a person can only be inside a switchgear if the switchgear itself is not powered and the earthing switch activated.

The new technique also addresses operational-related events, where some events give the operator a health indication of a mechanical part (e.g., racking-in/-out) and some events can harm to the switchgear itself (e.g., animal in the switchgear). The new technique enables the switching event of the circuit breaker to be detected and identified/classified. The switchgear event detection and its analysis and classification provide health information of the breaker, such as including the provision of information on the individual components of the breaker. The new technique also enables racking-in/-out to be detected and identified/classified: The racking-in/-out of the circuit breaker into the switchgear could harm or damage the contacts of the breaker busbars. Most of the time the worker or operator does not recognize the damage of the contacts. However, now by detecting and classifying this racking in/out event the operator gets feedback of the event, and whether it performed as expected or performed in an incorrect manner, which increases the safety of the equipment. The new technique also enables operation of the shutter mechanism to be detected and identified.: The shutter is part of the racking in/out mechanism, it is closed if the circuit breaker has been racked out and ensures protection against accidental contact to the busbar interface for the breaker to the switchgear. A broken shutter could damage the breaker arms or could lead to a severe accident, and the new technique enables it to be determined if a shutter that is broken has operated. The new technique enables for animal detection and identification. Animals could intrude the switchgear and cause harm to the switchgear by causing short circuits between the phases or a phase and ground. Such a short circuit leads to a major damage of the switchgear and a breakdown of the power grid, and the presence of an animal can be detected and identified.

The new technique also addresses environmental events, e.g., earthquake detection or strong vibrations from neighboring machines or vehicles that can be detected and identified and that could be used for an environment history profile to link certain events to certain breaks and failures of the switch.

Thus, the new technique provides for detecting safety-related events, operational-related events, and environmental events before they lead to harmful consequences and where acting upon such events is of high importance.

The switchgear event detection system, and switchgear event detection method, are now described in further specific detail, where reference is made to Figs. 2-5.

The new technique/development is based on three main features:
1. The application of switchgear monitoring to increase safety of workers on site and of the equipment. The monitoring results in less downtime due to failing equipment and due to unauthorized manipulations or trespassing.
2. The usage of vibration or acoustic sensors (one or multiple) in combination with a processing unit for measuring and detecting the critical events. The sensors can be placed in one of the compartments of the switchgear or outside on the wall of the switchgear. More information is described elsewhere.
3. The event detection, analysis, and classification of known and unknown critical events in and outside of a switchgear. Based on a classification algorithm, the operator gets meaningful feedback to take actions (e.g., a safety-critical warning).

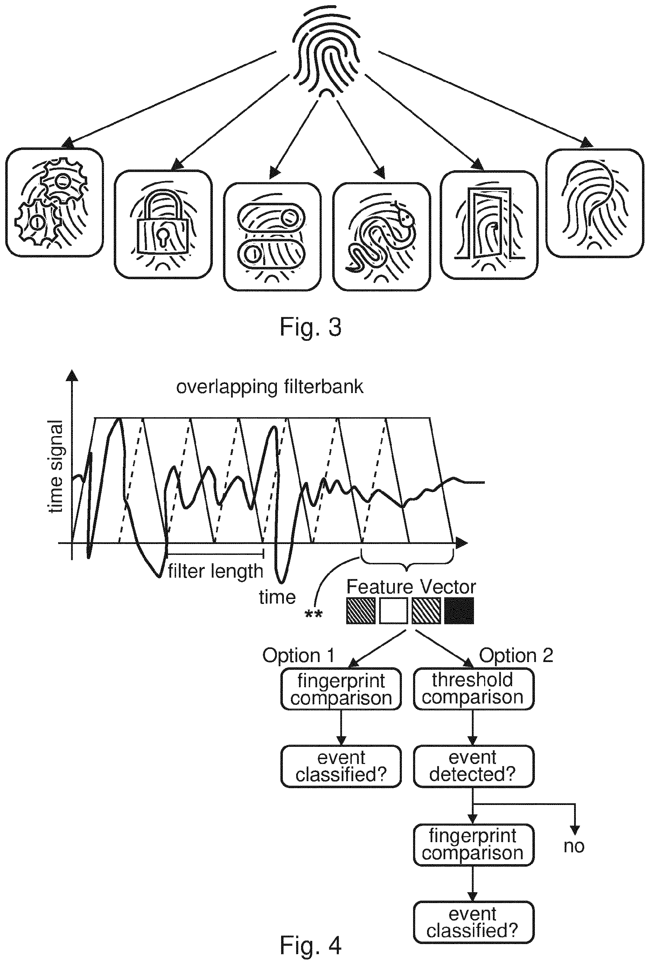

Fig. 2 shows an example of a switchgear event detection system, showing in effect operation of the analysis algorithm: For each measurement, an event fingerprint is created (see Fig. 3). A fingerprint consists of a defined set of features for each of the events. The different events can be characterized by the following signal properties none-limiting:
- Panel-interlocking: monitoring of grounding event, impulse excitation, low amplitudes
- Door closing/opening.: consecutive to panel-interlocking, medium-duration, low-amplitudes
- Human/person detection: medium-duration event, low to medium amplitudes, recurring patterns
- Switching event of the breaker: impulse excitation, short-duration event, large amplitudes
- Racking-in/-out: medium-duration event, medium amplitudes
- Shutter mechanism: short-duration event, medium amplitudes
- Animal detection: long-duration event, low amplitudes, recurring movement patterns
- Environmental events: long-duration event, low to medium amplitudes

Hence, these signal characteristics can be described and differentiated by a set of features to characterize event duration, amplitudes, repetitiveness. This results in a set of features:
i) Analytical features based on the envelope of the time signal (signal energy, peak energy, signal duration), Alignment of events by using time compression / stretching methods such as dynamic time warping and/or circular shifting to detect temporary patterns.
ii) Frequency and /or time-frequency characteristics such as specific coefficients or energy from Fourier transform, Wavelet transform or cepstral coefficients.
iii) Excitation frequency estimation by autocorrelation
iv) Also, the raw measurement signal itself can be used as a feature.

These features and combinations thereof can be extracted from the time signal by using an overlapping filterbank for segmentation (see Fig. 4). The filter length can be adjusted to the single features. A parallel implementation of several filterbanks with different filter lengths can also be utilized. Filterbanks are used in this case for time signal segmentation and or time windowing.

For each new segment (see Fig. 4, curly bracket highlighted at **), the selected features are computed. These features compose the fingerprint of a signal which can then be compared with a database. Optionally, an additional step can be implemented to implement a trigger method for each property/feature of the fingerprint (see Fig. 2). This method comprises, e.g., detection thresholds, deterministic or statistical methods. By using this event trigger, event classification is only triggered if any of the features result in a trigger. This can be implemented as a warning to the operator. If this step is omitted, any fingerprint is classified. For classification of events, any of / a combination of the following methods is used: feature thresholds, feature limits, similarity measures, correlation coefficient, machine learning algorithms, e.g., SVM etc.

If the event cannot be identified, it is classified as 'unknown'. There is a feedback loop for such events which triggers human interaction to manually classify these events. A newly classified event is then fed-back to the fingerprint database. In case the unknown event has manually been assigned to an existing class, a re-training of the detection algorithm is triggered.

Thus, the events such as switching, panel interlocking and racking can be classified as healthy events, and where deviating events will be classified as 'unknown', if the deviating event has not already been identified and stored in the event database, and can then be checked by the operator and, after successful manual classification, can be fed back to the event database.

### In summary

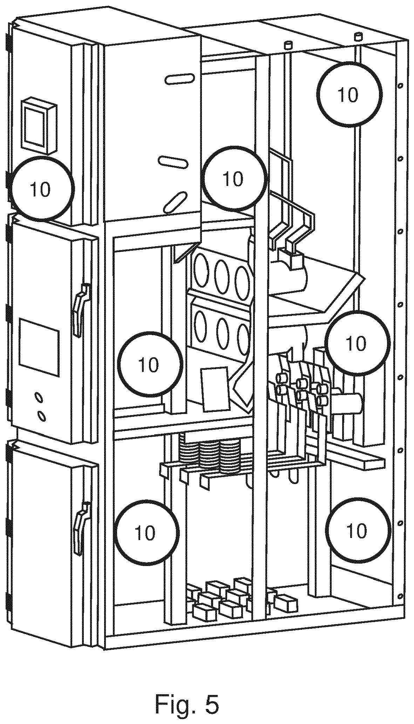

Thus, the new technique or development relates to the usage of vibration or acoustic sensors (one or multiple) in combination with a processing unit for measuring and detecting the critical events. The different sensor technologies of vibration and acoustic sensor are listed below. All sensors are placed in or on the switchgear. The sensors can be placed in one or multiple compartments of the switchgear or outside on the housing of the switchgear. Some examples of sensor placement in or outside the switchgear are shown in Fig. 5. The, or some of the sensors, can be place on or attached to components of the switchgear, such as on/to a circuit breaker, earthing switch, two/three position switch etc.

For each new sensor measurement / event detection, a fingerprint is created. This fingerprint consists of several features to characterize the significant properties of the signal. The fingerprint is then compared to a database which stores typical fingerprints for common safety critical events. Based on a classification algorithm, the event is then characterized and classified. Feedback to the operator is triggered (e.g., a safety-critical warning).

In the situation where an event cannot be related to a single event (unknown events), a generic alarm is triggered, and manual interaction can be utilized to identify the event and update the fingerprint database. The initial fingerprint database is created by using data from experiments/lab and/or field data of switchgears and indeed of a switchgear itself that is being monitored. The constant update and manual classification of unknown events provides for a capability to ever improve the system.

Benefits include:
1. Increased safety of workers on site.
2. Increased safety of the equipment.

### Example list of possible vibration sensors:

Piezoelectric accelerometer
High Impedance Accelerometer
MEMS Capacitive Accelerometers
Strain Gauge sensor
Eddy-Current or Capacitive Displacement sensor
laser vibrometer
Gyroscope
Electromagnetic induction vibration sensor
Ferraris-Sensor
Bulk micromachined capacitive
Bulk micromachined piezoelectric resistive
Capacitive spring mass system base DC response
Electromechanical servo (servo force balance)
Laser accelerometer
Modally tuned impact hammers
Optical
Pendulous integrating gyroscopic accelerometer (PIGA)
Quantum (rubidium atom cloud, laser cooled)
Seat pad accelerometers
Shear mode accelerometer
Surface acoustic wave (SAW)
Surface micromachined capacitive (MEMS)
Thermal (submicrometre CMOS process)
Triaxial
Vacuum diode with flexible anode
potentiometric type
LVDT type accelerometer
Inclinometer

### Example list of possible acoustic sensors:

MEMS Microphone
Condenser Microphones
Dynamic Microphones
Multi-Pattern Microphones
Carbon Microphones
Externally Polarized, Prepolarized, and ICP^{®} Microphones
Laser acoustic Microphones
Body acoustic Microphones
Piezoelectric Microphones
Magnetic Microphones
Piezoelectric Microphones
Aerospace Surface Microphone
Surface Microphone
Acoustic Arrays Microphone

In another exemplary embodiment, a computer program or computer program element is provided that is characterized by being configured to execute the method steps of the method according to one of the preceding embodiments, on an appropriate processor or system.

The computer program element might therefore be stored on a computer unit, which might also be part of an embodiment. This computing unit may be configured to perform or induce performing of the steps of the method described above. Moreover, it may be configured to operate the components of the above described system. The computing unit can be configured to operate automatically and/or to execute the orders of a user. A computer program may be loaded into a working memory of a data processor. The data processor may thus be equipped to carry out the method according to one of the preceding embodiments.

This exemplary embodiment of the invention covers both, a computer program that right from the beginning uses the invention and computer program that by means of an update turns an existing program into a program that uses the invention.

Further on, the computer program element might be able to provide all necessary steps to fulfill the procedure of an exemplary embodiment of the method as described above.

According to a further exemplary embodiment of the present invention, a computer readable medium, such as a CD-ROM, USB stick or the like, is presented wherein the computer readable medium has a computer program element stored on it which computer program element is described by the preceding section.

A computer program may be stored and/or distributed on a suitable medium, such as an optical storage medium or a solid state medium supplied together with or as part of other hardware, but may also be distributed in other forms, such as via the internet or other wired or wireless telecommunication systems.

However, the computer program may also be presented over a network like the World Wide Web and can be downloaded into the working memory of a data processor from such a network. According to a further exemplary embodiment of the present invention, a medium for making a computer program element available for downloading is provided, which computer program element is arranged to perform a method according to one of the previously described embodiments of the invention.

## Claims

1. A switchgear event detection system, comprising:
- one or more vibration/acoustic sensors (10);
- a processing unit (20); and
- an output unit (30);
wherein the one or more vibration/acoustic sensors are configured to be mounted in and/or on a switchgear;
wherein the one or more vibration/acoustic sensors are configured to acquire one or more vibration/acoustic signals relating to an event inside the switchgear and/or outside the switchgear and in the vicinity of the switchgear, and wherein the one or more vibration/acoustic signals extend over a time window;
wherein the one or more vibration/acoustic sensor are configured to provide the one or more vibration/acoustic signals to the processing unit;
wherein the processing unit is configured to compare at least a portion of the one or more vibration/acoustic signals with a plurality of reference vibration/acoustic signals stored within a database (40), wherein the plurality of reference vibration/acoustic signals relate to a N different reference events and wherein information of the N different reference events is stored in the database, and wherein each reference event of the N different reference events is associated with a different one or more reference vibration/acoustic signals of the plurality of reference vibration/acoustic signals;
wherein the processing unit is configured to classify the event as a specific reference event of the N different reference events when a match of the comparison between the at least a portion of the one or more vibration/acoustic signals relating to the event and the one or more reference vibration/acoustic signals of the plurality of reference vibration/acoustic signals associated with the specific reference event exceeds a first threshold; and
wherein the output unit is configured to output information on the event comprising utilization of information of the specific reference event stored in the database.

2. System according to claim 1, wherein the N different reference events comprises reference events inside at least one reference switchgear and/or outside the at least one reference switchgear; and/or the N different reference events comprises reference events inside the switchgear and/or outside the switchgear.

3. System according to any of claims 1-2, wherein the database is comprised within the processing unit.

4. System according to any of claims 1-2, wherein the database is separate to the processing unit.

5. System according to any of claims 1-4, wherein the processing unit is configured to classify the event as an unknown event when matches of comparisons between the at least a portion of the one or more vibration/acoustic signals relating to the event and each of the plurality of reference vibration/acoustic signals are less than the first threshold.

6. System according to claim 5, wherein the processing unit is configured to classify the event as an unknown event when matches of comparisons between the at least a portion of the one or more vibration/acoustic signals relating to the event and each of the plurality of reference vibration/acoustic signals are greater than a second threshold.

7. System according to any of claims 5-6, wherein the processing unit is configured to control the output unit to output an alarm when the event has been classified as an unknown event.

8. System according to any of claims 5-7, wherein the processing unit is configured to control the output unit to output information relating the event when the event has been classified as an unknown event, wherein the system comprises an input unit (50), and wherein the input unit is configured to enable information on the event to be input by an operator, wherein the information on the event classifies the event, and wherein the processing unit is configured to update the database with the one or more vibration/acoustic signals relating to the event that is stored as new one or more reference vibration/acoustic signals along with the information on the event that classified the event.

9. System according to any of claims 1-8, wherein the processing unit is configured to cut each of the one or more vibration/acoustic signals relating to the event into a plurality of segments each extending over a different part of the time window, and wherein the processing unit is configured to compare each segment of the one or more vibration/acoustic signals with the plurality of reference vibration/acoustic signals stored within the database (40), and wherein the processing unit is configured to classify the event as the specific reference event of the N different reference events when matches of comparisons between two or more segments of the plurality of segments of the one or more vibration/acoustic signals relating to the event and the one or more reference vibration/acoustic signals of the plurality of reference vibration/acoustic signals associated with the specific reference event exceed the first threshold.

10. System according to claim 9 when dependent upon any of claims 5-8, wherein the processing unit is configured to classify the event as an unknown event when matches of comparisons between two or more segments of the one or more vibration/acoustic signals relating to the event and each of the plurality of reference vibration/acoustic signals are less than the first threshold.

11. System according to claim 10, wherein the processing unit is configured to classify the event as an unknown event when matches of comparisons between the two or more segments of the one or more vibration/acoustic signals relating to the event and each of the plurality of reference vibration/acoustic signals are greater than the second threshold.

12. System according to any if claims 9-11, wherein at least one segment of the plurality of segments extends over a different time period to at least one other segment of the plurality of segments.

13. A switchgear comprising a system according to any of claims 1-12-

14. A switchgear event detection method, comprising:
- acquiring, by one or more vibration/acoustic sensors mounted in and/or on a switchgear, one or more vibration/acoustic signals relating to an event inside the switchgear and/or outside the switchgear and in the vicinity of the switchgear, and wherein the one or more vibration/acoustic signals extend over a time window;
- providing, by the one or more vibration/acoustic sensor, the one or more vibration/acoustic signals to a processing unit;
- comparing, by the processing unit, at least a portion of the one or more vibration/acoustic signals with a plurality of reference vibration/acoustic signals stored within a database (40), wherein the plurality of reference vibration/acoustic signals relate to a N different reference events and wherein information of the N different reference events is stored in the database, and wherein each reference event of the N different reference events is associated with a different one or more reference vibration/acoustic signals of the plurality of reference vibration/acoustic signals;
- classifying, by the processing unit is configured to classify the event as a specific reference event of the N different reference events when a match of the comparison between the at least a portion of the one or more vibration/acoustic signals relating to the event and the one or more reference vibration/acoustic signals of the plurality of reference vibration/acoustic signals associated with the specific reference event exceeds a first threshold; and
- outputting, by an output unit, information on the event comprising utilizing information of the specific reference event stored in the database.

15. A computer program element for controlling a system which when executed by a processor is configured to carry out the method of claim 14.
